# EUROPÄISCHE PATENTSCHRIFT

(11) **EP 2 027 605 B1**
(45) Veröffentlichungstag und Bekanntmachung des Hinweises auf die Patenterteilung: **15.12.2010**
(21) Anmeldenummer: 07722412.9
(22) Anmeldetag: 10.05.2007
(51) Int. Cl.: H01L 31/048, H01L 31/0216

(54) **PHOTOVOLTAIKMODUL MIT MINDESTENS EINER KRISTALLINEN SOLARZELLE und Herstellungsverfahren dazu**
PHOTOVOLTAIC MODULE WITH AT LEAST ONE CRYSTALLINE SOLAR CELL and corresponding method
MODULE PHOTOVOLTAIQUE COMPORTANT AU MOINS UNE CELLULE SOLAIRE CRISTALLINE et son procédé de fabrication

(30) Priorität: 10.05.2006 DE 102006021990
(43) Veröffentlichungstag der Anmeldung: 25.02.2009
(73) Patentinhaber: SITEC Solar GmbH, 16816 Neuruppin (DE)
(72) Erfinder: ALBRECHT, Dirk, 16833 Fehrbellin (DE)
(74) Vertreter: Bittner, Thomas L.
(86) Internationale Anmeldenummer: PCT/DE2007/000863
(87) Internationale Veröffentlichungsnummer: WO 2007/128305

(56) Entgegenhaltungen:
- EP-A- 1 202 354
- WO-A-99/56317
- US-A- 4 444 992
- US-A1- 2003 000 568

## Beschreibung

Die Erfindung betrifft ein Photovoltaikmodul mit mindestens einer kristallinen Solarzelle sowie ein Verfahren zum Herstellen.

### Hintergrund der Erfindung

Ein Photovoltaikmodul oder Solarmodul dient zur direkten Erzeugung von elektrischem Strom aus Sonnenlicht. Diese technische Einrichtung besteht aus einem Verbundsystem mehrerer Komponenten. Es können Photovoltaikmodule mit amorphen Solarzellen einerseits und Photovoltaikmodule andererseits unterschieden, bei denen eine zuvor erzeugte kristalline Solarzelle auf einem Trägersubstrat angeordnet wird. Bei den Photovoltaikmodulen mit amorphen Solarzellen, wie sie beispielsweise in dem Dokument DE 40 26 165 C2 verwendet werden, werden die Solarzellen beispielsweise mittels Dünnschichttechnologie auf einem Trägersubstrat Schritt für Schritt abgeschieden, um so die die Energicumwandlung realisierende Schichtstruktur zu schaffen. Das Trägersubstrat, beispielsweise Glas, bildet dann praktisch einen inhärenten und notwendigen Bestandteil der erzeugten amorphen Solarzellen.

Im Unterschied hierzu umfassen kristalline Solarzelle als photoaktives Element ein kristallines Material, üblicherweise in Form eines kristallinen Halbleiters wie zum Beispiel Silizium. Kristalline Solarzellen werden zunächst in einer separaten Herstellung erzeugt, um sie dann später als bereits existierende Bauelemente in Photovoltaikmodule zu integrieren.

Bei der Verwendung von kristallinen Solarzellen für das Photovoltaikmodul ist üblicherweise ein Materialverbund aus Glas als Trägermaterial, einem Einbettungs- oder Einkapselungsmaterial zur Aufnahme der eigentlichen kristallinen Solarzelle mit Verschaltung und einer Rückseitenkonstruktion oder -abdeckung vorgesehen. Das Einkapselungsmaterial dient dazu, die kristalline Solarzelle vor mechanischen und chemischen Einflüssen zu schützen. Insbesondere ist die Wasserdampfdurchlässigkeit ein Problem für die Solarzellen. Aufgrund von Korrosion der Metallkontakte (Stromabnehmer) kommt es zum Ausfall einzelner Solarzellen oder zum Ausfall des Moduls, da die Solarzellen seriell verschalten werden. In den meisten der derzeit handelsüblichen Photovoltaikmodule mit kristallinen Solarzellen wird das Material EVA (Etyl-Vinyl-Acetat) verwendet. Es hat die Eigenschaft, bei 150°C zu schmelzen und dadurch blasenfrei die Solarzelle und die Verbindereinzuschließen. Gleichzeitig findet eine thermische Vernetzung des Materials statt. Außer EVA werden noch weitere Materialien verwendet.

Aus dem Dokument EP 0 436 205 A2 ist bekannt, Methylmethacrylat mittels UV-Licht oder Tageslicht auszuhärten. Nach dem Dokument DE 198 46 160 A1 werden kristalline Solarzellen in eine Schmelzfolie eingebettet. Im Dokument DE 203 02 045 U1 wird eine PVB-Folie (Polyvinyl-Bural-Folie) verwendet, um die Solarzellen zu verkleben.

Auf den Herstellungsprozeß der Photovoltaikmodule mit kristallinen Solarzellen aus den Einzelkomponenten entfallen etwa 30% der Kosten. Diese Kosten werden verursacht durch den hohen Anteil an nicht automatisierbaren Produktionsschritten und durch lange Prozeßzeiten beim Laminieren des Endproduktes. Das EVA als Standardmaterial benötigt etwa 15 bis 30min zum Vernetzen. In dieser Zeit wird die Produktionsmaschine belegt und kann für kein weiteres Produkt benutzt werden. Ein kontinuierlicher durchlaufender Produktionsprozeß ist nicht möglich.

Ein weiterer Nachteil von EVA ist, daß es nicht UV-langzeitbeständig ist. Eine EVA-Schicht befindet sich zwischen Glasscheibe und kristalliner Solarzelle, also im optisch aktiven Bereich. Das Sonnenlicht muß diese Zone durchlaufen. Modullebenszeiten betragen mindestens 20 Jahre. In dieser Zeit altert das EVA durch chemische Degradation. Neuere EVA-Materialien verlieren etwa 20% ihrer Lichtdurchlässigkeit in dieser Zeit. Dadurch ist auch ein Leistungsabfall des Moduls zu verzeichnen. Auch die anderen vorgeschlagenen Materialien haben diese Problem. Es wird durch den Einsatz von UV-Stabilisatoren versucht, dies zu umgehen. Es ist jedoch nur ein zeitliches Verlangsamen des Alterungsprozesses.

Ein weiterer Nachteil aller beschriebenen Verkapselungsmaterialien besteht darin, daß es sich um Kunststoffe handelt. Kunststoffe haben einen wesentlich höheren Wärmeausdehnungskoeffizienten (50 bis 150 x 10⁻⁶ K⁻¹) als Silizium (2 x 10⁻⁶ K⁻¹) oder Glas (4 x 10⁻⁶ K⁻¹). Sollen nun Photovoltaikzellen aus Silizium mit Kunststoffen verkapselt werden, müssen die kristallinen Solarzellen von dem Kunststoff durch geeignete weiche Klebeschichten mechanisch entkoppelt werden. Dieses Problem löst EVA nur ungenügend.

Alle vorgeschlagenen Materialien ist gemeinsam, daß sie als Verarbeitungsprozeß einen Laminiervorgang benötigen. Hierbei wird unter Druck und Temperatur eine dauerhafte feste und dichte Verbindung der Schichten erreicht. Das Kunststoffmaterial wird hierbei auf Temperaturen erwärmt, bei denen es zumindest verformbar wird. Hierbei treten eine Reihe von unerwünschten Effekten auf, zum Beispiel das Verschieben der kristallinen Solarzellen im Laminator, das Austreten von Material an den Modulrändern, ein ungleichmäßiger Schichtaufbau in der Höhe und das Einlaminieren von mechanischen Spannungen an den Solarzellenverbindem. Ausfälle von Photovoltaikmodulen mit diesen Fehlerquellen sind hinlänglich bekannt. Dieser Laminierprozeß verursacht hohe Prozeßzeiten und damit hohe Kosten, ist schlecht automatisierbar und fehlerhafte Laminate können nicht mehr repariert werden.

Ein weiterer Nachteil dieser Technologie ist der Rückseitenaufbau des Photovoltaikmoduls. Hier kommen wiederum Kunststoffe zum Einsatz, beispielsweise Verbundfolien aus PVF (Polyvinylflorid) - PET (Polyethylenterephithalat) - PVF oder PVF - Aluminium - PVF. Kunststoffe haben jedoch die Eigenschaft, Wärme schlecht zu leiten. Bei Sonneneinstrahlung heizen sich die Module bis auf 80°C auf. Durch den negativen Temperaturkoeffizienten einer Solarzelle verringert sich die Leistung und damit der Wirkungsgrad des Moduls. Die Wärmeableitung aus der Solarzelle ist völlig unzureichend gelöst.

Aus dem Dokument US 2003/000568 A1 ist ein Photovoltaikmodul bekannt, bei dem auf eine Rückseite eines Trägersubstrats Solarzellen angeordnet werden, indem zunächst auf die Rückseite des Trägersubstrats ein transparenter leitender Oxydfilm aufgebracht wird, in welchen dann die Solarzellen eingelegt werden.

Im Dokument US 4,444,992 ist ein Photovoltaikmodul offenbart, bei dem Solarzellen mit Kontakten auf der Vorder- und der Rückseite rückseitig auf einem Trägersubstrat angeordnet werden und hierbei in einem Kapselungsmaterial platziert sind. In einer Ausführungsform sind die vorderseitigen Deckelektroden in eine Schicht eines Schichtstapels antireflektierender Schichten eingebettet.

Das Dokument WO 99/56317 beschreibt ein Photovoltaikmodul mit einer Anordnung elektrisch verbundener Solarzellen. Zwischen den Solarzellen sind Reflektoren angeordnet.

Das Dokument EP 1 202 354 A2 betrifft ein Photovoltaikmodul, bei dem mehrere Solarzellen auf einem rückseitigen Verstärkersubstrat angeordnet und in ein Kapselungsmaterial eingebettet sind.

### Zusammenfassung der Erfindung

Aufgabe der Erfindung ist es, ein Photovoltaikmodul mit mindestens einer kristallinen Solarzelle sowie ein Verfahren zum Herstellen eines Photovoltaikmoduls bereitzustellen, bei dem die optischen, mechanischen und chemischen Eigenschaften verbessert sind und die Herstellung schnell, kostengünstig und hoch automatisierbar ist.

Diese Aufgabe wird mit einem Photovoltaikmodul nach dem unabhängigen Anspruch 1 sowie ein Verfahren zum Herstellen nach dem unabhängigen Anspruch 17 gelöst. Vorteilhafte Ausgestaltungen der Erfindung sind Gegenstand von abhängigen Unteransprüchen.

Erfindungsgemäß ist ein Photovoltaikmodul geschaffen, bei dem auf einem Trägersubstrat mindestens eine kristalline Solarzelle angeordnet ist, mit der Lichtenergie in elektrische Energie wandelbar ist, eine Berührungsfläche zwischen dem Trägersubstrat und der mindestens einen kristallinen Solarzelle gebildet ist, wobei im Bereich der Berührungsfläche eine äußere Oberfläche auf einer Lichteinfallseite der mindestens einen kristallinen Solarzelle in Kontakt mit einer rückseitigen Oberfläche des Trägersubstratcs ist, und elektrische Anschlußkontakte auf der von der Lichteinfallseite abgewandten Rückseite der mindestens einen kristallinen Solarzelle angeordnet sind. Die Berührungsfläche ist über die gesamte äußere Oberfläche und durchgehend auf der Lichteinfällseite der mindestens einen kristallinen Solarzelle gebildet.

Das Trägersubstrat ist beispielsweise aus Glas oder Kunststoff, zum Beispiel Polycarbonat. Auf dem Trägersubstrat ist die kristalline Solarzelle ohne Zusatzstoffe, also haftmittelfrei aufgebracht. Es wird so erreicht, daß die Vorderseite der kristallinen Solarzelle frei ist und somit im Bereich der Berührungsfläche flächig am Trägersubstrat anliegen kann. Die kristalline Solarzelle hat direkten Kontakt zum Trägersubstrat. Das hat den Vorteil, daß es keine optische Komponente zwischen Trägersubstrat und Solarzellenvorderseite gibt. Hierdurch entfällt der optische Einfluß des vorderseitigen Einkapselungsmaterials, wie es im Stand der Technik vorgesehen ist. Da sich an dieser Stelle nun kein Material befindet, kommt es zu keinem Alterungsprozeß des optischen Mediums auf der Solarzellenvorderseite sondern zu einem ungehinderten Durchgang des Sonnenlichtes zur aktiven Solarzelle. Die bei bekannten Photovoltaikmodulen mit kristallenen Solarzellen beobachtete Leistungsreduzierung, die erfahrungsgemäß in 20 Jahren bis zu 20% beträgt, ist so vermieden. Die Lebensdauer und die Leistungsreduzierung hängt somit nur von der Qualität der Solarzelle selbst ab. Das Ergebnis ist eine erhebliche Verbesserung der Langzeitbeständigkeit von Photovoltaikmodulen.

Bei einer bevorzugten Ausführungsform der Erfindung ist eine die Berührungsfläche zumindest teilweise umgebende Randabdichtung vorgesehen.

Zweckmäßig sieht eine Weiterbildung der Erfindung vor, daß die Randabdichtung eine Befestigung der mindestens einen kristallinen Solarzelle an dem Trägersubstrat zumindest unterstützend gebildet ist.

Eine vorteilhafte Ausgestaltung der Erfindung kann vorsehen, daß die Randabdichtung die Berührungsfläche fluiddicht gegenüber einer äußeren Umgebung abdichtet.

Bevorzugt ist bei einer Fortbildung der Erfindung, daß die Randabdichtung sich in Eckbereiche erstreckt, in denen Seitenflächen der mindestens einen kristallinen Solarzelle und der rückseitigen Oberfläche des Trägersubstrates aneinanderstoßen.

Eine vorteilhafte Weiterbildung der Erfindung sieht vor, daß sich die Randabdichtung bis in einen Bereich einer von der Lichteinfallseite abgewandten Rückseite der mindestens einen kristallinen Solarzelle erstreckt.

Bei einer zweckmäßigen Ausgestaltung der Erfindung kann vorgesehen sein, daß die Randabdichtung die mindestens einen kristallinen Solarzelle auf der Rückseite flächig bedeckt, wahlweise im wesentlichen vollständig. Auf diese Weise ist ein mechanischer Schutz verbessert, insbesondere für die gesamte Solarzelle und die elektrischen Kontaktierungen. Darüber hinaus wird die thermische Ankopplung der kristallinen Solarzelle an einen Rückseitenaufbau erleichtert.

Bei einer bevorzugten Ausführungsform der Erfindung ist ein Wärmeverteil- und Wärmeabführsystem für an der mindestens einen Solarzelle erzeugte Wärmeenergie vorgesehen. Beim Herstellen des Photovoltaikmoduls wird in einem Ausführungsbeispiel das Wärmeverteil- und Wärmeabführsystem als ein Schichtverbund aufgetragen.

Zweckmäßig sieht eine Weiterbildung der Erfindung vor, daß das Wärmeverteil- und Wärmeabführsystem eine Wärmeleitschicht aus einem wärmeleitenden Material umfaßt, die an die mindestens eine kristalline Solarzelle thermisch gekoppelt ist.

Eine vorteilhafte Ausgestaltung der Erfindung kann vorsehen, daß das wärmeleitende Material ein Kunststoffmaterial ist.

Bevorzugt ist bei einer Fortbildung der Erfindung, daß die Wärmeleitschicht über einen Haftvermittler auf der von der Lichteinfallseite abgewandten Rückseite der mindestens einen kristallinen Solarzelle an die mindestens eine kristallinen Solarzelle thermisch gekoppelt ist.

Eine vorteilhafte Weiterbildung der Erfindung sieht einen Modulrückseitenabschluß aus einem weiteren wärmeleitenden Material vor.

Bei einer bevorzugten Ausführungsform der Erfindung ist vorgesehen, daß das weitere wärmeleitende Material ein Metall oder eine Metallegierung ist.

Zweckmäßig sieht eine Weiterbildung der Erfindung vor, daß das weitere wärmeleitende Material als eine Folien- oder eine Platte gebildet ist.

Bei einer vorteilhaften Weiterbildung der Erfindung kann vorgesehen sein, daß das Trägersubstrat zumindest einseitig mit einer optischen Antireflexbeschichtung versehen ist. Derartige Antireflexbeschichtungen sind als solche in verschiedenen Ausführungen bekannt. Die Beschichtung kann auf der der kristallinen Solarzelle zugewandten oder auf der hiervon abgewandten Seite des Trägersubstrates, bei dem es sich bevorzugt um Glas handelt, gebildet sein. Auch eine beidseitige Beschichtung kann vorgesehen sein. In den verschiedenen Ausgestaltungen wird so eine verlustärmere Lichteinkopplung des einfallenden Sonnelichtes auf die Solarzelle erreicht.

Eine vorteilhafte Ausgestaltung der Erfindung kann vorsehen, daß mindestens eine weitere kristalline Solarzelle gebildet ist, die wahlweise analog der mindestens einen kristallinen Solarzelle montiert ist, wobei die mindestens eine weitere kristalline Solarzelle und die mindestens eine kristalline Solarzelle über elektrische Anschlußkontakte auf der jeweiligen von der Lichteinfallseite abgewandten Rückseite miteinander verschalten sind.

### Beschreibun bevorzugter Ausführungsbeispiele der Erfindung

Die Erfindung wird im folgenden anhand von Ausführungsbeispielen unter Bezugnahme auf Figuren einer Zeichnung näher erläutert. Hierbei zeigen:
- Fig. 1: eine Anordnung mit einem Trägersubstrat für ein Photovoltaikmodul und mehreren hierauf angeordneten kristallinen Solarzellen von oben;
- Fig. 2: eine Abschnitt der Anordnung aus Fig. 1 im Querschnitt; und
- Fig. 3: ein Photovoltaikmodul unter Verwendung der Anordnung aus Fig. 1 im Querschnitt.

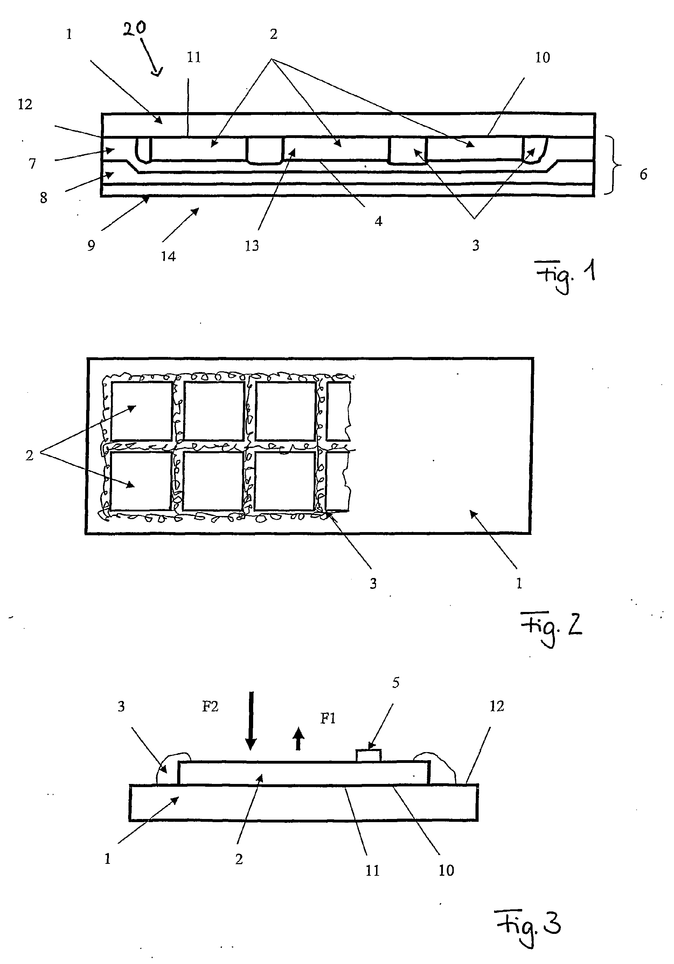

Fig. 1 zeigt eine Anordnung mit einem Trägersubstrat 1 für ein Photovoltaikmodul 20 und mehreren hierauf angeordneten und in sogenannter kristalliner Bauart ausgeführten Solarzellen 2 von oben. Die ein kristallines photoaktives Material aufweisenden Solarzellen 2 sind flächig nebeneinander mit einem geringen Abstand von etwa 2 bis 3mm angeordnet. Nach dem Positionieren der Solarzellen 2 wird um die Solarzellen 2 eine jeweilige Randabdichtung 3 aufgebracht. Mit diesem Aufbau wird ein fluiddichter Abschluß der Solarzellen 2 zum Trägersubstrat 1 erreicht, so daß eine Berührungsfläche zwischen den Solarzellen 2 und dem Trägersubstrat 1 insbesondere luftdicht eingeschlossen ist.

Fig. 2 zeigt die Ausbildung der Randabdichtung 3 für einen Abschnitt der Anordnung aus Fig. 1 im Querschnitt. Dieser Abschluß führt zu einem vergleichbaren Effekt wie bei der bekannten "Magdeburger Halbkugel". Die Kraft F1 ist der Kraft F2 (Luftdruck) entgegengesetzt. Es ist nicht möglich, die Solarzellen 2 vom Trägersubstrat 1 wieder zu lösen. In Experimenten war ein Ablösen selbst bei Kräften von bis 500kg / cm² nicht möglich.

In einer alternativen Ausgestaltung (nicht dargestellt) ist vorgesehen, die Randabdichtung 3 die Rückseite 4 der Solarzellen 2 teilweise oder vollständig flächig bedeckend aufzubringen. Hierdurch ist eine technologisch einfache Herstellung ermöglicht. Es wird der Bereich zwischen den Solarzellen 2 mit Klebstoff aufgefüllt, also eine Wandabdichtung ausgeführt. Gleichzeitig wird die Zellenrückseite mit den elektrischen Verbindern verklebt, beispielsweise mit einer flächigen Klebefolie oder einem flüssigen Klebstoff. Dieses kann vorzugsweise in einem technologischen Produktionsschritt ausgeführt werden.

Fig. 3 zeigt ein Photovoltaikmodul 20 unter Verwendung der Anordnung aus Fig. 1 im Querschnitt.

Nach dem Positionieren und dem Abdichten aller Solarzellen 2 werden die Solarzellen 2 auf der Rückseite 4 über Anschlußkontakte 5 kontaktiert und verschalten. Als weitere Schicht wird ein Laminataufbau oder Schichtverbund 6 aufgetragen aus einem Klebstoffschicht 7 mit einer Dicke von bis zu etwa 0.2mm, einer thermisch leitenden Isolierfolienschicht 8, die beispielsweise aus Polyimid ist, und einem Rückseitenabschluß 9 aus einer Metallschicht, vorzugsweise Aluminium. Mit dem Einsatz eines Metalls ist ein witterungsstabiler, wasser- und sauerstoff-undurchlässiger Rückseitenabschluß 9 gebildet.

Im Bereich einer äußeren Oberfläche 10 der Solarzellen 2 auf einer Lichteinfallseite ist ein jeweilige Berührungsfläche 11 gebildet, wo die äußere Oberfläche 10 in direktem Kontakt mit einer rückseitigen Oberfläche 12 des Trägersubstrates 1 ist, ohne daß ein Haftmittel vorgesehen ist.

Der Laminataufbau 6, welcher in anderen Ausgestaltungen weitere Schichten umfassen kann, erfüllt insbesondere wärmetechnische Funktionen. Durch die Einarbeitung der thermisch leitenden Isolierfolienschicht 8 direkt auf den Solarzellen 2 mittels der als Haftvermittler dienenden Klebstoffschicht 7 erfolgt ein Wärmeaustausch der Solarzellen 2 mit dem Rückseitenabschluß 9 aus Aluminium. Dadurch wird ein besserer Wärmedurchgang von einer Vorderseite 13 der Solarzellen auf eine Rückseite 14 des Photovoltaikmoduls 20 erreicht und hierdurch eine gleichmäßige Wärmeverteilung und Kühlung des Photovoltaikmoduls 20. Die Wärmeverteilung ist von großem Vorteil, da es bei Teilabschaltungen des Photovoltaikmoduls 20 zu Erwärmungen oder sogenannten Hot-Spot-Effekten in den Solarzellen 2 kommen kann. Diese überhitzen thermisch und können zum Teil zerstört werden. Bei einem Hot-Spot erwärmt sich eine Solarzelle 2 zum Teil lokal so stark, daß es zu Ablösungen des Laminataufbaus 6 vom Trägersubstrat 1 kommen kann, was zu einem optisch defekten Photovoltaikmodul 20 führt. Dieser Effekt wird mittels des beschriebenen Aufbaus des Photovoltaikmoduls 20 vermieden, da sich lokale Erwärmungen durch die thermische Leitfähigkeit der Rückseite flächig auf dem Photovoltaikmodul 20 verteilen können.

Der Rückseitenabschluß 9 aus Metall erfüllt weiterhin die Funktion eines Kühlkörpers für eine Modulanschlußdose. Im Photovoltaikmodul 20 werden Bypaßdioden (nicht dargestellt) zur Abschaltung von Solarzellenreihen verwendet. Die Bypaßdioden erzeugen Wärme im Durchflußfall. Die Wärme wird bei dem Photovoltaikmodul 20 auf den Rückseitenabschluß 9 übertragen und von dort abgegeben, wodurch die erforderliche Kühlung für die Bypaßdioden realisiert ist.

Der Laminataufbau 6 kann beim Herstellen in Einzelschritten aufgetragen oder vorzugsweise als vorgearbeitetes Teigprodukt in einem Prozeßschritt aufgebracht werden. Alle erläuterten Schritte des Verfahrens zum Herstellen des oben beispielhaft in einer Ausführungsform beschriebenen Photovoltaikmoduls 20 sind automatisierbar, einfach zu reproduzieren und besitzen kurze Prozeßzeiten. Fehler sind bis zum Auftragen der Rückseitenabschlusses 9 reparabel.

Die in der vorstehenden Beschreibung, den Ansprüchen und der Zeichnung offenbarten Merkmale der Erfindung können sowohl einzeln als auch in beliebiger Kombination für die Verwirklichung der Erfindung in ihren verschiedenen Ausführungsformen von Bedeutung sein.

## Patentansprüche

1. Photovoltaikmodul, bei dem auf einem Trägersubstrat (1) mindestens eine kristalline Solarzelle (2) angeordnet ist, mit der Lichtenergie in elektrische Energie wandelbar ist, wobei
- eine Berührungsfläche (11) zwischen dem Trägersubstrat (1) und der mindestens einen kristallinen Solarzelle (2) gebildet ist und
- im Bereich der Berührungsfläche (11) eine äußere Oberfläche (10) auf einer Lichteinfallseite der mindestens einen kristallinen Solarzelle (2) in Kontakt mit einer rückseitigen Oberfläche (12) des Trägersubstrates (1) ist,
**dadurch gekennzeichnet, daß**
- elektrische Anschlußkontakte (5) auf der von der Lichtcinfallseite abgewandten Rückseite (4) der mindestens einen kristallinen Solarzelle (2) angeordnet sind, über die die mindestens eine kristalline Solarzelle (2) auf der Rückseite (4) kontaktiert und verschaltet ist, und
- die Berührungsfläche (11) über die gesamte äußere Oberfläche (10) auf der Lichteinfallseite der mindestens einen kristallinen Solarzelle (2) und als durchgehende Berührungsfläche gebildet ist.

2. Photovoltaikmodul nach Anspruch 1, **gekennzeichnet durch** eine die Berührungsfläche (11) zumindest teilweise umgebende Randabdichtung (3).

3. Photovoltaikmodul nach Anspruch 2, **dadurch gekennzeichnet, daß** die Randabdichtung (3) eine Befestigung der mindestens einen kristallinen Solarzelle (2) an dem Trägersubstrat (1) zumindest unterstützend gebildet ist.

4. Photovoltaikmodul nach Anspruch 2 oder 3, **dadurch gekennzeichnet, daß** die Randabdichtung (3) die Berührungsfläche (11) fluiddicht gegenüber einer äußeren Umgebung abdichtet.

5. Photovoltaikmodul nach einem der Ansprüche 2 bis 4, **dadurch gekennzeichnet, daß** die Randabdichtung (3) sich in Eckbereiche erstreckt, in denen Seitenflächen der mindestens einen kristallinen Solarzelle (2) und der rückseitigen Oberfläche (12) des Trägersubstrates (1) aneinanderstoßen.

6. Photovoltaikmodul nach einem der Ansprüche 2 bis 5, **dadurch gekennzeichnet, daß** sich die Randabdichtung (3) bis in einen Bereich einer von der Lichteinfallseite abgewandten Rückseite (4) der mindestens einen kristallinen Solarzelle (2) erstreckt.

7. Photovoltaikmodul nach Anspruch 6, **dadurch gekenntzeichnet**, daß die Randabdichtung (3) die mindestens einen kristallinen Solarzelle (2) auf der Rückseite (4) flächig bedeckt, wahlweise im wesentlichen vollständig.

8. Photovoltaikmodul nach einem der vorangehenden Ansprüche, **gekennzeichnet durch** ein Wärmeverteil- und Wärmeabführsystem für an der mindestens einen kristallinen Solarzelle (2) erzeugte Wärmeenergie.

9. Photovoltaikmodul nach Anspruch 8, **dadurch gekennzeichnet, daß** das Wärmcvcrteil- und Wärmeabführsystem eine Wärmeleitschicht (8) aus einem wärmeleitenden Material umfaßt, die an die mindestens eine kristallinen Solarzelle (2) thermisch gekoppelt ist.

10. Photovoltaikmodul nach Anspruch 9, **dadurch gekennzeichnet, daß** das wärmeleitende Material ein Kunststoffmaterial ist.

11. Photovoltaikmodul nach Anspruch 9 oder 14, **dadurch gekennzeichnet, daß** die Wärmeleitschicht (8) über einen Haftvermittler (7) auf der von der Lichteinfallseite abgewandten Rückseite (4) der mindestens einen kristallinen Solarzelle (2) an die mindestens eine kristalline Solarzelle (2) thermisch gekoppelt ist.

12. Photovoltaikmodul nach einem der vorangehenden Ansprüche, **gekennzeichnet durch** einen Modulrückseitenabschluß (9) aus einem weiteren wärmeleitenden Material.

13. Photovoltaikmodul nach Anspruch 12, **dadurch gekennzeichnet, daß** das weitere wärmeleitende Material ein Metall oder eine Metallegierung ist.

14. Photovoltaikmodul nach Anspruch 12 oder 13, **dadurch gekenntzeichnet**, daß das weitere wärmeleitende Material als eine Folien- oder eine Platte gebildet ist.

15. Photovoltaikmodul nach einem der vorangehenden Ansprüche, **dadurch gekennzeichnet, daß** das Trägersubstrat (1) zumindest einseitig mit einer optischen Antireflexbeschichtung versehen ist.

16. Photovoltaikmodul nach einem der vorangehenden Ansprüche, **gekennzeichnet durch** mindestens eine weitere kristalline Solarzelle, die wahlweise analog der mindestens einen kristallinen Solarzelle montiert ist, wobei die mindestens eine weitere kristalline Solarzelle und die mindestens eine kristalline Solarzelle über elektrische Anschlußkontakte (5) auf der jeweiligen von der Lichteinfallseite abgewandten Rückseite (4) miteinander verschalten sind.

17. Verfahren zum Herstellen eines Photovoltaikmoduls, bei dem:
- ein Trägersubstrat bereitgestellt wird,
- auf dem Trägersubstrat (1) mindestens eine Solarzelle (2) angeordnet wird, mit der Lichtenergie in elektrische Energie wandelbar ist und bei der elektrische Anschlußkontakte (5) auf der von der Lichteinfallscitc abgewandten Rückseite (4) angeordnet sind,
- eine Berührungsfläche (11) zwischen dem Trägersubstrat (1) und der mindestens einen Solarzelle (2) gebildet wird,
- im Bereich der Berührungsfläche (11) eine äußere Oberfläche (10) auf einer Lichteinfallseite der mindestens einen Solarzelle (2) in direktem Kontakt mit einer rückseitigen Oberfläche (12) des Trägersubstratcs (1) ist,
- um die mindestens eine Solarzelle (2) eine Randabdichtung (3) aufgebracht wird, mit der die Berührungsfläche (11) fluiddicht gegenüber einer äußeren Umgebung abgedichtet wird,
- die mindestens eine Solarzelle (2) mittels der elektrischen Anschlußkontakte (5) auf der Rückseite (4) kontaktiert und verschaltet wird und
- ein Wärmeverteil- und Wärmeabführsystem für die mindestens eine Solarzelle (2) aufgetragen wird, bei dem eine Wärmeleitschicht aus einem wärmeleitenden Material an die mindestens eine Solarzelle (2) thermisch gekoppelt ist.

## Claims

1. A photovoltaic module, in which at least one crystalline solar cell (2), by means of which light energy can be converted into electrical energy, is arranged on a carrier substrate (1), wherein
- a contact area (11) is formed between the carrier substrate (1) and the at least one crystalline solar cell (2), and
- in the region of the contact area (11) an outer surface (10) on a light entry side of the at least one crystalline solar cell (2) is in contact with a rear surface (12) of the carrier substrate (1),
**characterized in that**
- electrical connection contacts (5) are arranged on the rear side (4) of the at least one crystalline solar cell (2) facing away from the light entry side by means of which the at least one crystalline solar cell (2) is connected and wired up at the rear side(4), and
- the contact area (11) is formed over the entire outer surface (10) on the light entry side of the at least one crystalline solar cell (2) and is formed as a continuous contact area.

2. The photovoltaic module according to claim 1, **characterized by** an edge seal (3) which at least partially surrounds the contact area (11).

3. The photovoltaic module according to claim 2, **characterized in that** the edge seal (3) is formed so as to at least assist a fixing of the at least one crystalline solar cell (2) to the carrier substrate (1).

4. The photovoltaic module according to claim 2 or 3, **characterized in that** the edge seal (3) seals off the contact area (11) from an external environment in a fluid-tight manner.

5. The photovoltaic module according to any one of claims 2 to 4, **characterized in that** the edge seal (3) extends into corner regions in which side faces of the at least one crystalline solar cell (2) and the rear surface (12) of the carrier substrate (1) butt against one another.

6. The photovoltaic module according to any one of claims 2 to 5, **characterized in that** the edge seal (3) extends into a region of the rear side (4) of the at least one crystalline solar cell (2) facing away from the light entry side.

7. The photovoltaic module according to claim 6, **characterized in that** the edge seal (3) optionally essentially completely covers the surface of the at least one crystalline solar cell (2) on the rear side (4).

8. The photovoltaic module according to any one of the preceding claims, **characterized by** a heat-distributing and heat-dissipating system for thermal energy generated on the at least one crystalline solar cell (2).

9. The photovoltaic module according to claim 8, **characterized in that** the heat-distributing and heat-dissipating system comprises a heat-conducting layer (8) made from a heat-conducting material which is thermally coupled to the at least one crystalline solar cell (2).

10. The photovoltaic module according to claim 9, **characterized in that** the heat-conducting material is a plastic material.

11. The photovoltaic module according to claim 9 or 10, **characterized in that** the heat-conducting layer (8) is thermally coupled to the at least one crystalline solar cell (2) via an adhesion promoter (7) on the rear side (4) of the at least one crystalline solar cell (2) facing away from the light entry side.

12. The photovoltaic module according to any one of the preceding claims, **characterized by** a module rear-side cover (9) made from a further heat-conducting material.

13. The photovoltaic module according to claim 12, **characterized in that** the further heat-conducting material is a metal or a metal alloy.

14. The photovoltaic module according to claim 12 or 13, **characterized in that** the further heat-conducting material is formed as a film or as a plate.

15. The photovoltaic module according to any one of the preceding claims, **characterized in that** the carrier substrate (1) is provided with an optical antireflection coating at least on one side.

16. The photovoltaic module according to any one of the preceding claims, **characterized by** at least one further crystalline solar cell which is optionally mounted analogously to the at least one crystalline solar cell, wherein the at least one further crystalline solar cell and the at least one crystalline solar cell are connected to one another via electrical connection contacts (5) on the respective rear side (4) facing away from the light entry side.

17. A method for producing a photovoltaic module, in which:
- a carrier substrate (1) is provided,
- at least one solar cell (2) is arranged on the carrier substrate (1), by means of which light energy can be converted into electrical energy and by which electrical connection contacts (5) are arranged on the rear side (4) facing away from the light entry side,
- a contact area (11) is formed between the carrier substrate (1) and the at least one solar cell (2),
- in the region of the contact area (11) an outer surface (10) on a light entry side of the at least one solar cell (2) is in direct contact with a rear surface (12) of the carrier substrate (1),
- an edge seal (3) is applied around the at least one solar cell (2), by which the contact area (11) is sealed off in a fluid-tight manner from an external environment,
- the at least one solar cell (2) is connected and wired up at the rear side (4) by means of electrical connection contacts (5), and
- a heat-distributing and heat-dissipating system for the at least one solar cell (2) is applied, by which a heat-conducting layer (8) made from a heat-conducting material is thermally coupled to the at least one solar cell (2).

## Revendications

1. Module photovoltaïque, dans lequel au moins une cellule solaire cristalline (2) qui permet de convertir l'énergie lumineuse en énergie électrique est disposée sur un substrat de support (1),
- une surface de contact (11) étant formée entre le substrat de support (1) et ladite au moins une cellule solaire cristalline (2) et
- dans la région de la surface de contact (11), une surface extérieure (10) sur un côté de la lumière incidente de ladite au moins une cellule solaire cristalline (2) étant en contact avec une surface arrière (12) du substrat de support (1),
**caractérisé en ce que**
- des contacts électriques (5) sont disposés sur la face arrière (4), opposée au côté de la lumière incidente, de ladite au moins une cellule solaire cristalline (2), au moyen desquels ladite au moins une cellule solaire cristalline (2) est mise en contact et connectée sur la face arrière (4), et
- la surface de contact (11) est formée sur toute la surface extérieure (10) du côté de la lumière incidente de ladite au moins une cellule solaire cristalline (2) et cela sous forme de surface de contact continue.

2. Module photovoltaïque selon la revendication 1, **caractérisé par** un joint périphérique (3) entourant au moins partiellement la surface de contact (11).

3. Module photovoltaïque selon la revendication 2, **caractérisé en ce que** le joint périphérique (3) est formé de manière à au moins contribuer à la fixation de ladite au moins une cellule solaire cristalline (2) sur le substrat de support (1).

4. Module photovoltaïque selon la revendication 2 ou 3, **caractérisé en ce que** le joint périphérique (3) rend la surface de contact (11) étanche aux fluides par rapport à un environnement extérieur.

5. Module photovoltaïque selon une des revendications 2 à 4, **caractérisé en ce** le joint périphérique (3) s'étend dans des régions de coin dans lesquelles des surfaces latérales de ladite au moins une cellule solaire cristalline (2) et de la surface arrière (12) du substrat de support (1) se rencontrent.

6. Module photovoltaïque selon une des revendications 2 à 5, **caractérisé en ce que** le joint périphérique (3) s'étend jusque dans une région d'une face arrière (4) opposée au côté de la lumière incidente de ladite au moins une cellule solaire cristalline (2).

7. Module photovoltaïque selon la revendication 6, **caractérisé en ce que** le joint périphérique (3) recouvre ladite au moins une cellule solaire cristalline (2) sur la face arrière (4) sur toute la surface, au choix sensiblement complètement.

8. Module photovoltaïque selon une des revendications précédentes, **caractérisé par** un système de répartition et de dissipation de la chaleur pour l'énergie thermique produite sur ladite au moins une cellule solaire cristalline (2).

9. Module photovoltaïque selon la revendication 8, **caractérisé en ce que** le système de répartition et de dissipation de la chaleur comprend une couche thermoconductrice (8) dans un matériau thermoconducteur, qui est couplée thermiquement à ladite au moins une cellule solaire cristalline (2).

10. Module photovoltaïque selon la revendication 9, **caractérisé en ce que** le matériau thermoconducteur est une matière plastique.

11. Module photovoltaïque selon la revendication 9 ou 10, **caractérisé en ce que** la couche thermoconductrice (8) est couplée thermiquement à ladite au moins une cellule solaire cristalline (2) par un agent adhésif (7) sur la face arrière (4), opposée au côté de la lumière incidente, de ladite au moins une cellule solaire cristalline (2).

12. Module photovoltaïque selon une des revendications précédentes, **caractérisé par** une terminaison arrière de module (9) dans un autre matériau thermoconducteur.

13. Module photovoltaïque selon la revendication 12, **caractérisé en ce que** l'autre matériau thermoconducteur est un métal ou un alliage métallique.

14. Module photovoltaïque selon la revendication 12 ou 13, **caractérisé en ce que** l'autre matériau thermoconducteur est réalisé sous la forme d'une feuille ou d'une plaque.

15. Module photovoltaïque selon une des revendications précédentes, **caractérisé en ce que** le substrat de support (1) est pourvu au moins d'un côté d'un revêtement anti-réflexion optique.

16. Module photovoltaïque selon une des revendications précédentes, **caractérisé par** au moins une autre cellule solaire cristalline qui, au choix, est montée de manière analogue à ladite au moins une cellule solaire cristalline, ladite au moins une autre cellule solaire cristalline et ladite au moins une cellule solaire cristalline étant connectées ensemble par des contacts électriques (5) sur la face arrière (4) respective opposée au côté de la lumière incidente.

17. Procédé pour fabriquer un module photovoltaïque, dans lequel :
- un substrat de support est mis à disposition,
- sur le substrat de support (1) est disposée au moins une cellule solaire (2) qui permet de convertir l'énergie lumineuse en énergie électrique et sur laquelle des contacts électriques (5) sont disposés sur la face arrière (4) opposée au côté de la lumière incidente,
- une surface de contact (11) est formée entre le substrat de support (1) et ladite au moins une cellule solaire (2),
- dans la région de la surface de contact (11), une surface extérieure (10) sur un côté de la lumière incidente de ladite au moins une cellule solaire (2) est en contact direct avec une surface arrière (12) du substrat de support (1),
- autour de ladite au moins une cellule solaire (2) est appliqué un joint périphérique (3) qui rend la surface de contact (11) étanche aux fluides par rapport à un environnement extérieur,
- ladite au moins une cellule solaire (2) est mise en contact et connectée au moyen des contacts électriques (5) sur la face arrière (4) et
- un système de répartition et de dissipation de la chaleur pour ladite au moins une cellule solaire (2) est appliqué, dans lequel une couche thermoconductrice dans un matérial thermoconducteur est couplée thermiquement à ladite au moins une cellule solaire (2).
